(19) Europäisches Patentamt / European Patent Office / Office européen des brevets

(11) **EP 4 225 001 A1**

(12) **EUROPEAN PATENT APPLICATION**
published in accordance with Art. 153(4) EPC

(43) Date of publication:
**09.08.2023 Bulletin 2023/32**

(21) Application number: **21874872.1**

(22) Date of filing: **21.07.2021**

(51) International Patent Classification (IPC):
**H05K 7/20** (2006.01)       **C08K 3/01** (2018.01)
**C08L 23/00** (2006.01)      **C08L 83/04** (2006.01)
**H01L 23/36** (2006.01)

(52) Cooperative Patent Classification (CPC):
**C08K 3/01; C08L 23/00; C08L 83/04; H01L 23/36; H05K 7/20**

(86) International application number:
**PCT/JP2021/027302**

(87) International publication number:
**WO 2022/070568 (07.04.2022 Gazette 2022/14)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **30.09.2020 JP 2020165565**

(71) Applicant: Sekisui Polymatech Co., Ltd.
**Saitama-city, Saitama 338-0837 (JP)**

(72) Inventors:
• **NAMIKI, Kazuhiro**
  **Saitama-city, Saitama 338-0837 (JP)**
• **IWAZAKI, Hiromichi**
  **Saitama-city, Saitama 338-0837 (JP)**
• **KUROO, Kenta**
  **Saitama-city, Saitama 338-0837 (JP)**
• **KUDOH, Hiroki**
  **Saitama-city, Saitama 338-0837 (JP)**

(74) Representative: **Ter Meer Steinmeister & Partner Patentanwälte mbB**
**Nymphenburger Straße 4**
**80335 München (DE)**

(54) **HEAT-CONDUCTIVE SHEET, METHOD FOR ATTACHING SAME AND METHOD FOR PRODUCING SAME**

(57)     Provided is a heat-conductive sheet including: a binder component that is a mixture of a silicone matrix (A) and a hydrocarbon compound (B); and a heat-conductive filler (C) dispersed in the binder component, wherein the heat-conductive sheet has a compression ratio at 80°C and 0.276 MPa of 15% or more and a shape retention.

Fig.1

EP 4 225 001 A1

**Description**

Technical Field

The present invention relates to a heat-conductive sheet, for example, a heat-conductive sheet that is used in a state in which it is disposed between a heating element and a heat sink.

Background Art

In electronic devices such as computers, car parts, and mobile phones, heat sinks such as heat sinks are generally used to dissipate heat generated from heating elements such as semiconductor elements and machine parts. It is known that a heat-conductive sheet is disposed between a heating element and a heat sink for the purpose of increasing the efficiency of heat transfer to the heat sink.

The heat-conductive sheet is required to have a followability to the heating element and the heat sink in order to further enhance the conduction efficiency. Accordingly, a phase-change-type heat-conductive sheet, a so-called phase change sheet, which is softened or melted by heating, has been studied. For example, PTL 1 discloses a heat-dissipation sheet that at least comprises an alkyl group-introduced silicone oil, an alpha-olefin, and heat-conductive filler, wherein the heat-dissipation sheet is putty-like at normal temperature and is softened to be fluidized by heating.

Further, a heat-conductive sheet including polymer gel is also known as a heat-conductive sheet. For example, PTL 2 discloses a thermally softened heat-dissipation sheet made of a composition that comprises polymer gel, a compound that is solid or paste-like at normal temperature and liquefied by heating, and heat-conductive filler, wherein the heat-dissipation sheet is softened by heating.

Further, PTL 3 discloses a heat-conductive sheet comprising a heat-conductive resin layer, wherein the heat-conductive resin layer comprises a binder resin containing a wax and a heat-conductive filler dispersed in the binder resin and silicone gel is used for the binder resin.

The phase change sheet and the heat-conductive sheets including polymer gel such as silicone gel disclosed in PTLs 1 to 3 above have a high softness and thus have a good followability to a heat sink and a heating element, thereby enhancing the thermal conductivity.

Citation List

Patent Literatures

**[0007]**

　　　PTL1: JP 2004-331835 A
　　　PTL2: JP 2002-234952 A
　　　PTL3: JP 2001-291807 A

Summary of Invention

Technical Problem

However, the heat-conductive sheets shown in PTLs 1 to 3 have insufficient shape retention due to insufficient resilience, thereby resulting in defects, such as a poor workability when installing the heat-conductive sheet and difficulty in producing it by cutting processing or the like. Further, they tend to have pump-outs and insufficient rebound resilience and thus may be problematic in reliability.

It is therefore an object of the present invention to provide a heat-conductive sheet that has a good shape retention and good reliability and also surely exhibits a certain softness during use to improve the thermal conductivity.

Solution to problem

As a result of diligent studies, the inventors have found that the aforementioned problems can be solved by providing a heat-conductive sheet comprising a predetermined binder component and a heat-conductive filler, wherein the heat-conductive sheet has a compression ratio at 80°C and 0.276 MPa (= 40 psi) of 15% or more and a shape retention, thereby accomplishing the present invention described below. Specifically, the present invention provides [1] to [11] below.

[1] A heat-conductive sheet comprising:

> a binder component that is a mixture of a silicone matrix (A) and a hydrocarbon compound (B); and
> a heat-conductive filler (C) dispersed in the binder component,
> wherein the heat-conductive sheet has a compression ratio at 80°C and 0.276 MPa of 15% or more, and has a shape retention.

[2] The heat-conductive sheet according to [1] above, wherein the hydrocarbon compound (B) has a melting point higher than 23°C and 80°C or less.

[3] The heat-conductive sheet according to [1] or [2] above, wherein the hydrocarbon compound (B) is crystalline polyalphaolefin.

[4] The heat-conductive sheet according to any one of [1] to [3] above, wherein the heat-conductive sheet has a content of the hydrocarbon compound (B) of 1 to 50 parts by mass, with respect to 100 parts by mass of a total of the silicone matrix (A) and the hydrocarbon compound (B).

[5] The heat-conductive sheet according to any one of [1] to [4] above, wherein the heat-conductive filler (C) comprises an anisotropic filler, and the anisotropic filler is oriented in the thickness direction.

[6] The heat-conductive sheet according to any one of [1] to [4] above, wherein a volume filling rate of the heat-conductive filler (C) is 30 to 85 vol%.

[7] A heat dissipating member comprising: the heat-conductive sheet according to any one of [1] to [6] above; and a heat sink, wherein the heat-conductive sheet is mounted on the surface of the heat sink.

[8] A method for mounting a heat-conductive sheet, the method comprising:

> a step of disposing the heat-conductive sheet on a surface of a first member, wherein the sheet comprises a binder component that is a mixture of a silicone matrix (A) and a hydrocarbon compound (B), and a heat-conductive filler (C) dispersed in the binder component, and has a shape retention;
> a step of heating the heat-conductive sheet; and
> a step of disposing a second member on a surface of the heat-conductive sheet, the surface being opposite from the first member side, and pressurizing the heat-conductive sheet, to install the heat-conducting sheet between the first and second members.

[9] The method for mounting a heat-conductive sheet according to [8] above, wherein the hydrocarbon compound (B) has a melting point higher than 23°C, and the heat-conductive sheet is heated to a temperature equal to or higher than the melting point or higher.

[10] A method for producing a heat-conductive sheet, the method comprising:

> a step of mixing at least a curable silicone composition (A1), a hydrocarbon compound (B), a heat-conductive filler (C), and a compatible substance (D), to obtain a mixed composition; and
> a step of curing the mixed composition by heating.

[11] The method for producing a heat-conductive sheet according to [10] above, wherein the compatible substance (D) is an alkoxysilane compound.

Advantageous Effect of Invention

The present invention can provide a heat-conductive sheet having a good shape retention and good reliability and also surely exhibits a certain softness during use to improve the thermal conductivity.

Brief Description of Drawing

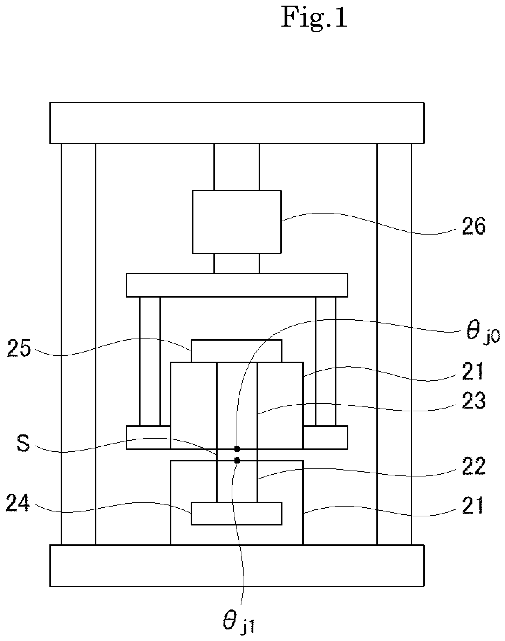

[Fig. 1] Fig. 1 is a diagram for illustrating a measuring machine to measure the heat resistance.

Description of Embodiments

[Heat-conductive sheet]

Hereinafter, a heat-conductive sheet according to an embodiment of the present invention will be described in detail.

The heat-conductive sheet of the present invention comprises a binder component that is a mixture of a silicone matrix (A) and a hydrocarbon compound (B), and a heat-conductive filler (C) dispersed in the binder component. In the present invention, the heat-conductive sheet has a compression ratio at 80°C and 0.276 MPa (= 40 psi) of 15% or more and also has a shape retention.

The heat-conductive sheet of the present invention, which has such features, surely has a certain softness when heated at high temperature (that is, during use), so as to surely exhibit a followability without applying a high load on a heating element, a heat sink, or the like, thereby improving the thermal conductivity. Further, since the heat-conductive sheet is easily compressed and thus is installed at a high compression ratio, the distance between particles of the heat-conductive filler (C) in the heat-conductive sheet is shortened, or particles of the heat-conductive filler (C) come into contact with each other, thereby improving the thermal conductivity.

Further, since the heat-conductive sheet has a shape retention, it is easily installed in an electronic device, it is also possible to process a block-like material into sheets by slicing thereby to produce heat-conductive sheets, as will be described later, and further, the handleability is excellent when the sheet has a certain resilience at around normal temperature. In addition, a predetermined rebound resilience is provided after installing, and pump-outs are less likely to occur, thus improving the reliability while ensuring the softness.

Although the mechanism of improving the reliability while ensuring the softness is not clear, it is presumed as follows. In the present invention, the hydrocarbon compound (B) is incompatible with the silicone matrix (A). Accordingly, it is presumed that the silicone matrix (A) serves as the sea component, and the hydrocarbon compound (B) serves as the island components in the binder component, thereby forming a sea-island structure. It is presumed that the binder component having a sea-island structure allows the hydrocarbon compound (B) to be held by the silicone matrix (A) even when the binder component is softened or melted, or has a reduced viscosity, so that pump-outs can be suppressed while enhancing the softness. Further, it is presumed that, since the silicone matrix (A) serving as the sea component allows the heat-conductive sheet to have a predetermined rebound resilience, no an air layer is formed between the heat-conductive sheet and a heating element or a heat sink so that the heat-conductive sheet can be easily installed in a stable manner.

When the compression ratio described above is less than 15%, the softness during heating is insufficient. Therefore, the heat-conductive sheet exhibits an insufficient followability to the heating element or the heat sink during use, and also cannot be installed at a high compression ratio, resulting in a reduction in thermal conductivity. The compression ratio is preferably 18% or less, more preferably 20% or more, in view of enhancing the softness during use to improve the thermal conductivity.

Further, the compression ratio is preferably 50% or less. The compression ratio of 50% or less facilitates improving the handleability and the reliability, and also facilitates install in electronic devices and cutting processing, and further when the compression ratio is 50% or less, pump-outs or the like are less likely to occur. In view of these, the compression ratio is more preferably 40% or less, further preferably 38% or less.

<Silicone matrix (A)>

The silicone matrix (A) is preferably silicone having no fluidity at any of room temperature (23°C) and high temperature (80°C). Since the silicone matrix (A) has no fluidity, the shape retention of the heat-conductive sheet can be ensured at normal temperature and high temperature.

For example, silicone rubber may be used as the silicone matrix (A) in the present invention. Use of silicone rubber facilitates compressive deformation so that the heat-conductive sheet can be installed easily between a heating element and a heat sink. Further, use of silicone rubber can impart a certain compression characteristic to the heat-conductive sheet, so that the reliability can be enhanced.

The silicone to be used for the silicone matrix (A) may be any of the condensation reaction type and the addition reaction type, and is preferably the addition reaction type because of the following reasons: a large amount of the heat-conductive filler is easily filled therein, and the curing temperature can be easily adjusted by a catalyst or the like. The silicone matrix (A) can be obtained, for example, by curing a curable silicone composition (A1). The curable silicone composition (A1) may consist, for example, of a base resin and a curing agent.

In the case where the curable silicone composition (A1) is of the addition reaction type, it preferably contains an alkenyl group-containing organopolysiloxane as a base resin and hydrogen organopolysiloxane as a curing agent, in view of ease of filling a large amount of the heat-conductive filler.

The curable silicone composition (A1) is preferably in a liquid form before curing. In the case where the curable silicone composition (A1) is in a liquid form before curing, a large amount of the heat-conductive filler can be easily filled therein, and also the hydrocarbon compound (B) is easily dispersed in the curable silicone composition (A1). Herein, a liquid form means a liquid at normal temperature (23°C) and a pressure of 1 atm.

Further, it is preferable to use a three-dimensionally crosslinked silicone matrix as the silicone matrix (A), in view of ensuring the shape retention of the heat-conductive sheet. In the case of, for example, an addition reaction type, this purpose may be achieved by curing a curable silicone composition (A1) containing: an alkenyl group-containing organopolysiloxane having at least three or more alkenyl groups in one molecule; or a hydrogen organopolysiloxane having at least three or more hydrogen atoms added to a silicon atoms.

The content of the silicone matrix (A) may be, for example, about 15 to 70 vol%, preferably 17 to 50 mass%, more preferably 20 to 39 mass%, with respect to the total amount of the heat-conductive sheet.

<Hydrocarbon compound (B)>

The hydrocarbon compound (B) to be used in the present invention may be a liquid compound at room temperature or a compound that is capable of being melted by heating at a certain temperature (for example, a temperature over 23°C and 80°C or less). In the case where the heat-conductive sheet contains as the hydrocarbon compound (B) a liquid compound or a compound that is capable of being melted by heating, the heat-conductive sheet can exhibit enhanced softness when heated at high temperature and thus can easily increase the aforementioned compression ratio.

The melting point of the hydrocarbon compound (B) is preferably 80°C or less, more preferably 70°C or less, further preferably 60°C or less, even more preferably 50°C or less, in view of melting the compound by heating at high temperature (for example, 80°C).

The hydrocarbon compound (B) is preferably in a solid form at room temperature and a pressure of 1 atm. In the case where the compound is in a solid form at room temperature, the handleability can be enhanced, and for example, when performing the later-described cutting processing at a temperature around room temperature, the heat-conductive sheet can be easily obtained due to a predetermined rigidity. Accordingly, the melting point of the hydrocarbon compound is preferably higher than normal temperature (23°C), more preferably 30°C or more, further preferably 35°C or more. The melting point of the hydrocarbon compound is the temperature of the endothermic peak in the DTA curve measured using thermogravimetric differential thermal analysis (TGDTA) at a heating rate 1°C/min. Further, in the case where the hydrocarbon compound is a mixture of hydrocarbon compounds, the melting point is the maximum endothermic peak in the aforementioned temperature range.

Specific examples of the hydrocarbon compound include liquid paraffin, paraffin waxes, vaseline, polyalphaolefin (PAO), polyethylene waxes, and polypropylene waxes. Among these, paraffin waxes, vaseline, polyalphaolefin (PAO), polyethylene waxes, and polypropylene waxes are preferable, in view of the handleability at normal temperature. Vaseline is a semi-solid hydrocarbon compound, which is a mixture of a plurality of hydrocarbon compounds including isoparaffin, cycloparaffin, and naphthene. Examples of vaseline can also include white vaseline defined in the Japanese Pharmacopoeia.

Among them, polyalphaolefin (PAO) is preferable, and especially, crystalline polyalphaolefin (CPAO) having crystallinity is more preferable. Polyalphaolefin is a polymer of alpha-olefins. The type of the alpha-olefins is not particularly limited, and they may have a linear or branched chain, or a cyclic structure. Polyalphaolefin is, for example, a polymer of alpha-olefins having 2 to 30 carbon atoms, preferably having 6 to 20 carbon atoms. The number of carbon atoms of alpha-olefins may be increased, for example, so that the crystalline polyalphaolefin may be a side-chain crystalline polyalphaolefin.

Polyalpha-olefin may be a polymer of single alpha-olefins or may be a copolymer of two or more alpha-olefins.

The content of the hydrocarbon compound (B) in the heat-conductive sheet is preferably 1 to 50 parts by mass, with respect to 100 parts by mass of a total of the silicone matrix (A) and the hydrocarbon compound (B).

When the content of the hydrocarbon compound (B) is 1 part by mass or more, the heat-conductive sheet has a certain softness at high temperature, and the thermal conductivity of the heat-conductive sheet after installed between a heating element and a heat sink tends to be improved.

When the content is 50 parts by mass or less, a certain amount of the silicone matrix (A) is contained in the heat-conductive sheet, and the shape retention of the heat-conductive sheet can be improved. Further, the heat-conductive sheet tends to have an appropriate rebound resilience, and no air layer is formed between the heat-conductive sheet and the heating element or the heat sink so that the heat-conductive sheet can be easily installed in a stable manner, resulting in high reliability.

From these viewpoints, the content of the hydrocarbon compound (B) is more preferably 3 parts by mass or more, further preferably 5 parts by mass or more, furthermore preferably 8 parts by mass or more, and more preferably 40 parts by mass or less, further preferably 30 parts by mass or less, furthermore preferably 25 parts by mass or less.

The silicone matrix (A) is formed from the curable silicone composition (A1), which will be described below. Accordingly, the content of the hydrocarbon compound (B) in the later-described mixed composition with respect to 100 parts by mass of a total of the curable silicone composition (A1) and the hydrocarbon compound (B) is the same as in the content of the hydrocarbon compound (B) described above. The same also applies to the contents of the heat-conductive filler (C), the anisotropic filler, and the non-anisotropic filler, which will be described below.

Further, the binder component preferably consists of the silicone matrix (A) and the hydrocarbon compound (B), but the binder component may contain a resin component other than the silicone matrix (A), a plasticizer other than the hydrocarbon compound (B), or others, as long as the effects of the present invention are not impaired.

<Heat-conductive filler (C)>

The heat-conductive sheet of the present invention further comprises the heat-conductive filler (C). The heat-conductive filler (C) is preferably dispersed in the binder component that is a mixture of the silicone matrix (A) and the hydrocarbon compound (B) to be held by the binder component.

The heat-conductive filler may be an anisotropic filler or a non-anisotropic filler, or both of them may be used in combination. The heat-conductive filler preferably includes at least an anisotropic filler, more preferably includes both of an anisotropic filler and a non-anisotropic filler. The heat-conductive sheet tends to enhance the thermal conductivity when containing an anisotropic filler.

The anisotropic filler are preferably oriented in one direction, and specifically, preferably oriented in the thickness direction of the heat-conductive sheet. When the anisotropic filler is oriented in the thickness direction, the thermal conductivity in the thickness direction tends to be enhanced. Further, when oriented in the thickness direction, the aforementioned compression ratio in the thickness direction is difficult to increase; however, in the present invention, the hydrocarbon compound (B) dispersed in the silicone matrix (A) can increase the compression ratio in the thickness direction.

When the anisotropic filler is oriented in the thickness direction, the long-axis direction is not necessarily strictly parallel to the thickness direction, and the long-axis direction inclined to some extent in the thickness direction is also considered to be oriented in the thickness direction. Specifically, those with the long-axis direction inclined at about less than 20° are also considered to be an anisotropic filler oriented in the thickness direction, and when such anisotropic filler are predominant (for example, over 60%, preferably over 80%, with respect to the total number of particles of the anisotropic filler) in the heat-conductive sheet, they are considered to be oriented in the thickness direction.

Further, in the above description, the anisotropic filler has been explained on the premise that they are oriented in the thickness direction; however, the same applies to the case where they are oriented in another direction.

The content of the heat-conductive filler (C) is preferably 150 to 3000 parts by mass, more preferably 200 to 2000 parts by mass, further preferably 300 to 1000 parts by mass, with respect to 100 parts by mass of a total of the silicone matrix (A) and the hydrocarbon compound (B). When the content of the heat-conductive filler (C) are 150 parts by mass or more, a certain thermal conductivity can be imparted to the heat-conductive sheet. When the content is 3000 parts by mass or less, the heat-conductive filler (C) can be appropriately dispersed in the binder component. Further, it is possible to prevent the viscosity of the mixed composition, which will be described below, from increasing higher than necessary.

Further, the volume filling rate of the heat-conductive filler is preferably 30 to 85 vol%, more preferably 50 to 83 vol%, further preferably 61 to 80 vol%, with respect to the total amount of the heat-conductive sheet. When the volume filling rate is the aforementioned lower limit or more, a certain thermal conductivity can be imparted to the heat-conductive sheet. When the volume filling rate is the upper limit or less, the heat-conductive sheet is easily produced.

(Anisotropic filler)

The anisotropic filler is a filler that has an anisotropic shape and is capable of being oriented. Examples of the anisotropic filler include fiber materials and flaky materials. The anisotropic filler has a high aspect ratio, specifically, an aspect ratio of over 2, and preferably has an aspect ratio of 5 or more. An anisotropic filler having an the aspect ratio over 2 easily orients in one direction, for example, the thickness direction, and thus the thermal conductivity in the one direction, for example, the thickness direction of the heat-conductive sheet is easily enhanced. Further, the upper limit of the aspect ratio is not specifically limited, but is practically 100.

The aspect ratio is the ratio of the length in the long-axis direction to the length in the short-axis direction of the anisotropic filler. The aspect ratio means the fiber length/the fiber diameter when it is a fiber material, and means the length in the long-axis direction of a flake/the thickness thereof when it is a flaky material.

The content of the anisotropic filler in the heat-conductive sheet is preferably 10 to 500 parts by mass, more preferably 30 to 300 parts by mass, further preferably 50 to 250 parts by mass, with respect to 100 parts by mass of a total of the silicone matrix (A) and the hydrocarbon compound (B).

When the content of the anisotropic filler is 10 parts by mass or more, the thermal conductivity is easily enhanced. Further, when it is 500 parts by mass or less, the viscosity of the mixed composition, which will be described below, tends to be appropriate, and the orientation of the anisotropic filler is improved. Further, the dispersibility of the anisotropic filler in the silicone matrix (A) is also improved.

In the case where the anisotropic filler is a fiber material, the average fiber length is preferably 10 to 500 $\mu$m, more preferably 20 to 350 $\mu$m, further preferably 50 to 300 $\mu$m. Fibers of an anisotropic filler having an average fiber length of 10 $\mu$m or more are appropriately in contact with each other inside the heat-conductive sheet, to ensure a heat transfer path, so that the thermal conductivity of the heat-conductive sheet is improved.

When the anisotropic filler has an average fiber length of 500 $\mu$m or less, the bulk of the anisotropic filler is low, so that a large amount thereof can be filled in the binder component.

The average fiber length of fiber materials is preferably shorter than the thickness of the heat-conductive sheet. The average fiber length shorter than the thickness prevents the fiber materials from protruding from the surface of the heat-conductive sheet more than necessary.

The average fiber length can be calculated through observing the anisotropic filler with a microscope. More specifically, the fiber lengths of any 50 fibers of the anisotropic filler are measured, for example, using an electron microscope or optical microscope, and the average (arithmetic mean) thereof can be taken as an average fiber length.

In the case where the anisotropic filler is a flaky material, the average particle size is preferably 10 to 400 $\mu$m, more preferably 15 to 300 $\mu$m, further preferably 20 to 200 $\mu$m. Flakes of the anisotropic filler having an average particle size of 10 $\mu$m or more are easily in contact with each other in the heat-conductive sheet, to surely create a heat transfer path, so that the thermal conductivity of the heat-conductive sheet is improved. When the anisotropic filler has an average particle size of 400 $\mu$m or less, the bulk of the heat-conductive sheet to be low, so that a large amount of the anisotropic filler can be filled in the binder component.

The average particle size of the flaky material can be calculated by observing the anisotropic filler with a microscope and determining the major diameter as a diameter. More specifically, the major diameters of any 50 flakes of anisotropic filler are measured, for example, using an electron microscope or optical microscope, and the average (arithmetic mean) thereof can be taken as an average particle size.

As the anisotropic filler, any known material having a thermal conductivity may be used. The anisotropic filler is preferably diamagnetic in the case where it is to be oriented by the magnetic field orientation, as will be described below. The anisotropic filler may not be diamagnetic in the case where it is to be oriented by fluidized orientation or not oriented.

Specific examples of the anisotropic filler include carbon materials typified by carbon fibers and flaky carbon powder, metal materials typified by metal fibers, and metal oxides, boron nitride, metal nitride, metal carbide, metal hydroxide, and polyparaphenylene benzoxazole fibers. Among these, carbon materials are preferable in view of having a small specific gravity and a good dispersibility in the binder component. Among them, graphitized carbon materials having a high thermal conductivity are more preferable. A graphitized carbon material is diamagnetic when the graphite planes are aligned in a predetermined direction.

Boron nitride is also preferable as the anisotropic filler. Boron nitride is preferably used in the form of a flaky material, but is not limited thereto. The flaky boron nitride may be agglomerated or may not be agglomerated, but the flaky boron nitride is preferably partially or fully agglomerated. The boron nitride or the like is also diamagnetic when the crystal planes are aligned in a predetermined direction.

The anisotropic filler generally have a thermal conductivity in the anisotropic direction (that is, long-axis direction) of 30 W/m.K or more, preferably 60 W/m.K or more, more preferably 100 W/m.K or more, further preferably 200 W/m.K or more, without specific limitation. The upper limit of the thermal conductivity of the anisotropic filler is not specifically limited, but is, for example, 2000 W/m.K or less. The thermal conductivity can be measured by the laser flash method or the like.

A single type of the anisotropic filler may be used alone, or two or more types of them may be used in combination. For example, at least two anisotropic fillers having different average particle sizes or average fiber lengths may be used as the anisotropic filler. It is considered that, when the anisotropic fillers having different sizes are used, particles of the small anisotropic filler enter between particles of the relatively large anisotropic filler, so that the binder component can be filled with the anisotropic fillers at a high density, and the heat conduction efficiency can thus be enhanced.

The carbon fiber used as the anisotropic filler is preferably a graphitized carbon fiber. Flaky graphite powder is preferable as flaky carbon powder. It is also preferable to use the graphitized carbon fiber and the flaky graphite powder in combination as the anisotropic filler.

The graphitized carbon fiber has graphite crystal planes aligned in the fiber axis direction and thus has high thermal conductivity in the fiber axis direction. Therefore, the thermal conductivity in a specific direction can be enhanced by aligning the fiber axis directions in a predetermined direction. The flaky graphite powder has graphite crystal planes aligned in the plane direction of the flake surface and thus has high thermal conductivity in the plane direction. Therefore, the thermal conductivity in a specific direction can be enhanced by aligning the flake surfaces in a predetermined direction. The graphitized carbon fiber and flaky graphite powder each preferably have a high degree of graphitization.

As the graphitized carbon materials such as graphitized carbon fibers and flaky graphite powder described above, graphitized products of the following raw materials can be used. Examples of the raw materials include condensed polycyclic hydrocarbon compounds such as naphthalene, PAN (polyacrylonitrile), and condensed heterocyclic compounds such as pitch. In particular, graphitized mesophase pitch, polyimide, or polybenzazole having a high degree of graphitization is preferably used. For example, when mesophase pitch is used, the pitch is oriented in the fiber axis direction due to its anisotropy in the spinning step, which will be described below, to give graphitized carbon fibers having excellent thermal conductivity in the fiber axis direction.

The form of the mesophase pitch used for the graphitized carbon fiber is not specifically limited, as long as it can be spun, and the mesophase pitch may be used alone or in combination with another raw material. However, use of the mesophase pitch alone, or in other words, a graphitized carbon fiber with a mesophase pitch content of 100% is most preferable in view of high thermal conductivity, spinnability, and quality stability.

The graphitized carbon fibers to be used may be those obtained by sequentially performing spinning, infusibilization, and carbonization, pulverizing or cutting into a predetermined particle size, and then graphitizing, or those obtained by carbonizing, pulverizing or cutting, and then graphitizing. In the case where pulverizing or cutting is performed before graphitization, a graphitized carbon fiber with a further improved thermal conductivity can be obtained, since polycondensation reaction and cyclization reaction are likely to proceed during graphitization on the surface newly exposed by pulverization, to enhance the degree of graphitization. In the case where the spun carbon fiber is pulverized after graphitization, the carbon fiber after graphitization is rigid and thus easy to pulverize, and carbon fiber powder having a relatively narrow fiber length distribution can be obtained by pulverization in a short time.

The average fiber length of the graphitized carbon fiber is preferably 10 to 500 $\mu$m, more preferably 20 to 350 $\mu$m, further preferably 50 to 300 $\mu$m, as mentioned above. The aspect ratio of each graphitized carbon fiber is over 2, preferably 5 or more, as mentioned above. The thermal conductivity of the graphitized carbon fiber is not specifically limited, but the thermal conductivity in the fiber axis direction is preferably 400 W/m.K or more, more preferably 800 W/m.K or more.

In the case where the heat-conductive sheet contains the anisotropic filler, the anisotropic filler may be exposed or may not be exposed on the sheet surface, but are preferably exposed. The sheet surface of the heat-conductive sheet can be a non-adhesive surface due to exposure of the anisotropic filler. The heat-conductive sheet serves as the main surface of the sheet, and the anisotropic filler may be exposed on any one of both faces of the sheet or may be exposed on both faces. In the case where the heat-conductive sheet has a non-adhesive sheet surface, it can be slid when it is installed into an electronic device or the like, improving the installability.

(Non-anisotropic filler)

The non-anisotropic filler is a material that imparts thermal conductivity to the heat-conductive sheet when used alone or together with the anisotropic filler. Particularly, when used in combination with the anisotropic filler oriented in one direction, the non-anisotropic filler can intervene in the gap between particles of the oriented anisotropic filler, to further increase the thermal conductivity. The non-anisotropic filler is a filler that has substantially no anisotropy in shape and is not oriented in a predetermined direction even under an environment in which anisotropic filler is oriented in a predetermined direction, such as under the generation of magnetic force lines or the action of shear force, which will be described below.

The non-anisotropic filler has an aspect ratio of 2 or less, preferably 1.5 or less. When used in combination with the anisotropic filler, the non-anisotropic filler having such a low aspect ratio is likely to be positioned in the gaps between the anisotropic filler and thus tends to improve the thermal conductivity. Further, the non-anisotropic filler having an aspect ratio of 2 or less can prevent increase of the viscosity of the mixed composition, which will be described below, to achieve high filling rate.

Specific examples of the non-anisotropic filler include metals, metal oxides, metal nitrides, metal hydroxides, carbon materials, and oxides, nitrides, and carbides of others than metals. Examples of the shape of the non-anisotropic filler include spherical or amorphous powder.

For the non-anisotropic filler, examples of the metals include aluminum, copper, and nickel; examples of the metal oxides include aluminum oxide typified by alumina, magnesium oxide, and zinc oxide; and examples of the metal nitrides include aluminum nitride. Examples of the metal hydroxides include aluminum hydroxide. Examples of the carbon materials include spherical graphite. Examples of the oxides, nitrides, and carbides of others than metals include quartz, boron nitride, and silicon carbide.

Among these, aluminum oxide and aluminum are preferable, in view of their high thermal conductivity and availability of spherical materials.

The non-anisotropic fillers described above may be used singly or in combination of two or more.

The average particle size of the non-anisotropic filler is, for example, 0.1 to 200 $\mu$m. For example, when used in combination with the anisotropic filler, the average particle size of the non-anisotropic filler is preferably 0.1 to 50 $\mu$m, more preferably 0.5 to 35 $\mu$m, further preferably 1 to 15 $\mu$m. When the average particle size is 50 $\mu$m or less, defects such as disturbing the orientation of the anisotropic filler are less likely to occur, even when used in combination with the anisotropic filler. When the average particle size is 0.1 $\mu$m or more, the non-anisotropic filler has a specific surface area not increased more than necessary, and even when such a non-anisotropic filler is contained in a large amount, the viscosity of the mixed composition is difficult to increase so that a large amount of the non-anisotropic filler is easily filled.

As the non-anisotropic filler, at least two non-anisotropic fillers having different average particle sizes may be used, for example.

When using the non-anisotropic filler(s) singly as the heat-conductive filler (C), the average particle size is preferably 0.1 to 200 $\mu$m, more preferably 0.5 to 100 $\mu$m, further preferably 1 to 70 $\mu$m. In this case, two or more non-anisotropic fillers having different average particle sizes are preferably used in combination, and a small-particle size heat-conductive filler having average particle size of 0.1 $\mu$m or more and 5 $\mu$m or less and a large-particle size heat-conductive filler having an average particle size of over 5 $\mu$m and 200 $\mu$m or less are preferably used in combination, in view of enhancing the thermal conductivity of the heat-conductive sheet. When using the small-particle size heat-conductive filler and the large-particle size heat-conductive filler in combination, their mass ratio (large-particle size heat-conductive filler/small-particle size heat-conductive filler) is preferably 0.1 to 10, more preferably 0.3 to 7, further preferably 1 to 5.

The average particle size of the non-anisotropic filler can be measured through observation with an electron microscope or the like. More specifically, the particle sizes of any 50 particles of the non-anisotropic filler are measured, for example, using an electron microscope or optical microscope, and the average (arithmetic mean) thereof can be taken as an average particle size.

The content of the non-anisotropic filler is preferably 50 to 2500 parts by mass, more preferably 100 to 1500 parts by mass, further preferably 200 to 750 parts by mass, with respect to 100 parts by mass of a total of the silicone matrix (A) and the hydrocarbon compound (B). When it is 50 parts by mass or more, the thermal conductivity of the heat-conductive sheet can be improved. When it is 2500 parts by mass or less, the non-anisotropic filler are appropriately dispersed in the binder component, and the effect of enhancing the thermal conductivity according to the content can be obtained. Also, the viscosity of the mixed composition can be prevented from increasing more than necessary.

The mass ratio of the content of the non-anisotropic filler to the content of the anisotropic filler is not specifically limited but is preferably 0.5 to 5, more preferably 1 to 3, preferably 1.1 to 2.5. When the mass ratio is within the aforementioned range, particles of the non-anisotropic filler can be appropriately filled between particles of the anisotropic filler to form an efficient heat transfer path, and thus the thermal conductivity of the heat-conductive sheet can be furthermore improved.

(Additives)

In the heat-conductive sheet, the binder component may further contain various additives, as long as the functions of the heat-conductive sheet are not impaired. Examples of the additives include at least one or more selected from dispersants, coupling agents, pressure-sensitive adhesives, flame retardants, antioxidants, colorants, and anti-settling agents. When curing the curable silicone composition (A1) as mentioned above, a curing catalyst or the like to accelerate curing may be contained as an additive. Examples of the curing catalyst include a platinum catalyst.

The mixed composition may contain a compatible substance (D), as will be described below. The compatible substance (D) may volatilize in the process of producing the heat-conductive sheet so as not to remain, or the compatible substance (D) contained may at least partially remain, in the heat-conductive sheet.

The heat-conductive sheet has a shape retention, as described above. The heat-conductive sheet has a shape retention not only at normal temperature (23°C) but also at high temperature (for example, 80°C). The heat-conductive sheet does not lose the elasticity at high temperature to ensure the shape retention. Specifically, the sheet is compressed by 50% between a pair of flat plates, held at 80°C in the compressed state for 2 hours, then cooled to normal temperature (23°C) (natural cooling), and released from the compressed state, and 30 minutes later, the thickness is measured, to calculate the strain (compressive strain) before and after the test using the following formula. Strain (%) = (thickness of sample before test - thickness of sample after test)/(thickness of sample before test - thickness of sample in compressed state) $\times$ 100

The heat-conductive sheet of the present invention may have a strain of 50% or less. Further, the strain is preferably 40% or less, further preferably 30% or less. Such a strain can be achieved when the amount of the hydrocarbon compound (B), which is a phase change material, to be added is set to a predetermined amount or less. For example, when the amount of the phase change material is the predetermined amount or more, the strain increases. In the case where the phase change material is a matrix, the phase change material solidifies in a compressed state, resulting in that the strain is 90 to 100%. The lower limit of the strain is preferably as small as possible, and, for example, the lower limit is 1% or more.

The heat-conductive sheet preferably has a certain hardness or higher. Specifically, when the compression ratio of the heat-conductive sheet at 80°C and 0.276 MPa (= 40 psi) falls within the aforementioned range, not only the followability to heating elements or heat sinks during use, but also the reliability are excellent, and pump-outs or the like are less likely to occur.

The thickness of the heat-conductive sheet is not specifically limited, and the thickness may be appropriately set according to the shape and application of the electronic device on which the heat-conductive sheet is mounted, and the thickness is, for example, in the range of 0.1 to 5 mm.

[Method for producing heat-conductive sheet]

The heat-conductive sheet of the present invention can be produced by a production method including step X and step Y below.

Step X: the step of mixing at least the curable silicone composition (A1), the hydrocarbon compound (B), the heat-conductive filler (C), and the compatible substance (D), to obtain a mixed composition
Step Y: the step of curing the mixed composition obtained in step X by heating

Hereinafter, each step will be described in detail.

(Step X)

In step X, the curable silicone composition (A1), the hydrocarbon compound (B), and the heat-conductive filler (C), and, in addition, the compatible substance (D) are mixed to obtain a mixed composition. The compatible substance (D) is a substance that is compatible to or dissolved in the hydrocarbon compound (B) and the curable silicone composition (A1). The hydrocarbon compound (B) has a lower compatibility with the curable silicone composition (A1), but can be uniformly mixed with the curable silicone composition (A1) by using the compatible substance (D). Therefore, the hydrocarbon compound (B) is uniformly mixed in the silicone matrix (A), which is to be obtained by curing the curable silicone composition (A1).

In step X, the mixing method and the mixing order are not specifically limited, as long as a mixed composition can be obtained by mixing the aforementioned components. The curable silicone composition (A1), the hydrocarbon compound (B), the heat-conductive filler (C), the compatible substance (D), and any other components to be added as required may be appropriately mixed in any order, to obtain a mixed composition.

The curable silicone composition (A1) is, for example, composed of a base resin and a curing agent, as mentioned above, and in such a case, the base resin, the curing agent, the hydrocarbon compound (B), the heat-conductive filler (C), the compatible substance (D), and any other components added as required may be mixed in any order, to obtain a mixed composition.

The hydrocarbon compound (B) is preferably dissolved in the compatible substance (D) before being mixed with the curable silicone composition (A1) and other components.

In this case, a mixture of the hydrocarbon compound (B) and the compatible substance (D), the curable silicone composition (A1) (or the base resin and the curing agent), the heat-conductive filler (C), and any other components added as required may be mixed in any order, to obtain a mixed composition.

When the hydrocarbon compound (B) is dissolved in the compatible substance (D) in step X in this way, the hydrocarbon compound (B) can be mixed in the silicone matrix (A) more uniformly.

In the case where the hydrocarbon compound (B) is dissolved in the compatible substance (D), they may be appropriately heated. The heating temperature is preferably higher than the melting point of the compatible substance (D) and may be, for example, 40°C or more for dissolution. In the case where the compatible substance (D) is mixed in the base resin and the curing agent, the upper limit of the heating temperature may be a temperature at which the thermal conductive silicone does not substantially cure in the process of mixing. In the case where the compatible substance (D) is mixed in each of the base resin and the curing agent, the upper limit can be a temperature at which the compatible substance (D) is difficult to volatilize and may be, for example, 80°C or less for dissolution.

The mixed state of the silicone matrix (A) and the hydrocarbon compound (B) is a homogeneous mixture that is transparent or slightly cloudy due to the presence of the compatible substance (D). In the case where the compatible substance (D) is not contained, a solid hydrocarbon compound is dispersed in the silicone matrix (A), or a liquid hydrocarbon compound is separated to form two layers.

<Compatible substance (D)>

The compatible substance (D) to be used in the present invention is preferably a substance that is dissolved in the hydrocarbon compound (B) and is compatible with the curable silicone composition (A1). The compatible substance (D) is preferably a substance that is liquid at normal temperature (23°C) and a pressure of 1 atm. The compatible substance (D) is, for example, a component that volatilizes by heating at about 50 to 180°C in step Y, as will be described below. Since the compatible substance (D) volatilizes by heating at the time of the curing, the content of the heat-conductive filler (C) in the heat-conductive sheet can be increased. Further, the mixed composition has a reduced viscosity due to containing the compatible substance (D). Therefore, the amount of the heat-conductive filler (C) to be mixed are easily increased, and further the anisotropic filler is easily oriented in a predetermined direction by magnetic field orientation or the like, which will be described below.

Examples of the compatible substance (D) include alkoxysilane compounds, hydrocarbon solvents, and alkoxysiloxane compounds. These compounds have high solubility or compatibility with the hydrocarbon compound (B) and the curable silicone composition (A1), and thus can enhance the dispersibility of the hydrocarbon compound (B) in the curable silicone composition (A1) in the mixed composition. Thus, the hydrocarbon compound (B) is appropriately dispersed also in the heat-conductive sheet, and as a result, the shape retention, the reliability, the softness at high temperature, and the like are easily ensured.

The compatible substance (D) may be used singly or in combination of two or more.

The compatible substance (D) to be used is preferably an alkoxysilane compound. In the case where the alkoxysilane compound is used, the appearance is improved, and specifically, air voids or the like are not seen in the surface of the heat-conductive sheet obtained by curing.

The alkoxysilane compound to be used as the compatible substance (D) is a compound having a structure in which, among the 4 bonds from a silicon atom (Si), 1 to 3 bonds each attach to an alkoxy group, and the residual bonds each attach to an organic substituent. The alkoxysilane compound, which has the alkoxy group(s) and the organic substituent(s), can enhance the dispersibility of the hydrocarbon compound (B) in the curable silicone composition (A1).

Examples of the alkoxy group of the alkoxysilane compound include methoxy groups, ethoxy groups, protoxy groups, butoxy groups, pentoxy groups, and hexatoxy groups. In the curable silicone composition (A1), the alkoxysilane compound may be contained in the form of a dimer.

Among such alkoxysilane compounds, an alkoxysilane compound having at least either one of a methoxy group and an ethoxy group is preferable, in view of the availability. The number of alkoxy groups in the alkoxysilane compound is preferably 2 or 3, more preferably 3, in view of the compatibility, the solubility, and the like, with the curable silicone composition (A1) and the hydrocarbon compound (B). Specifically, the alkoxysilane compound is preferably at least one selected from trimethoxysilane compounds, triethoxysilane compounds, dimethoxysilane compounds, and diethoxysilane compounds.

Examples of the functional group contained in the organic substituent of the alkoxysilane compound include an acryloyl group, an alkyl group, a carboxyl group, a vinyl group, a methacryl group, an aromatic group, an amino group, an isocyanate group, an isocyanurate group, an epoxy group, a hydroxyl groups, and a mercapto group. Here, when using a platinum catalyst as a curing catalyst of the curable silicone composition (A1), an alkoxysilane compound that is difficult to affect the curing reaction of organopolysiloxane is preferably selected and used. Specifically, when using an addition reaction type organopolysiloxane with a platinum catalyst, the organic substituent of the alkoxysilane compound is preferably free from an amino group, an isocyanate group, an isocyanurate group, a hydroxyl group, or a mercapto group.

The alkoxysilane compound preferably contains an alkylalkoxysilane compound having an alkyl group bound to a silicon atom, that is, an alkoxysilane compound having an alkyl group as an organic substituent, in view of enhancing the dispersibility of the hydrocarbon compound (B) in the silicone matrix (A). Accordingly, a dialkyl dialkoxysilane compound and an alkyltrialkoxysilane compound are preferable, and among them, an alkyltrialkoxysilane compound is preferable.

The number of carbon atoms of the alkyl group bound to the silicon atom may be, for example, 1 to 16. In the trialkoxysilane compound such as trimethoxysilane compounds and triethoxysilane compounds, the number of carbon atoms of the alkyl group is preferably 6 or more, further preferably 8 or more, and preferably 12 or less, more preferably 10 or less, in view of enhancing the dispersibility of the hydrocarbon compound.

In the dialkoxysilane compound such as dimethoxysilane compounds and diethoxysilane compounds, the number of carbon atoms of the alkyl group may be 1 or more, and is preferably 10 or less, more preferably 6 or less, further preferably 4 or less, in view of enhancing the dispersibility of hydrocarbon compound.

Examples of the alkyl group-containing alkoxysilane compound include methyltrimethoxysilane, dimethyldimethoxysilane, diethyldimethoxysilane, trimethylmethoxysilane, methyltriethoxysilane, dimethyldiethoxysilane, ethyltrimethoxysilane, n-propyltrimethoxysilane, di-n-propyldimethoxysilane, din-propyldiethoxysilane, isobutyltrimethoxysilane, isobutyltriethoxysilane, isobutyltrimethoxysilane, isobutyltriethoxysilane, n-hexyltrimethoxysilane, n-hexyltriethoxysilane, methylcyclohexyldimethoxysilane, methylcyclohexyldiethoxysilane, n-octyltrimethoxysilane, n-octyltriethoxysilane, n-decyltrimethoxysilane, and n-decyltriethoxysilane.

Among the alkyl group-containing alkoxysilane compounds, n-decyltrimethoxysilane, dimethyldimethoxysilane, and n-octyltriethoxysilane are further preferable, in view of improving the dispersibility of the hydrocarbon compound (B), and n-decyltrimethoxysilane and n-octyltriethoxysilane are furthermore preferable, in view of the solubility in the hydrocarbon compound (B).

An alkoxysiloxane compound used as the compatible substance (D) has two or more siloxane bonds, and has a structure in which at least one silicon atom has an alkoxy group. The alkoxysiloxane compound has a structure in which at least one of the silicon atoms constituting the siloxane bond has an organic substituent. The alkoxysiloxane compound, which has an alkoxy group and an organic substituent, can enhance the dispersibility of the hydrocarbon compound (B).

Examples of the alkoxy group and the organic substituent of the alkoxysiloxane compound include those described above for the alkoxysilane compound, and the alkoxysiloxane compound preferably has at least an alkyl group in view of enhancing the dispersibility of the hydrocarbon compound (B).

Examples of the alkoxysiloxane compound include methylmethoxysiloxane oligomer, methylphenylmethoxysiloxane oligomer, methylepoxymethoxysiloxane oligomer, methylmercaptomethoxysiloxane oligomer, and methylacryloylmethoxysiloxane oligomer.

The alkoxysiloxane compounds may be used singly or in combination of two or more.

Examples of the hydrocarbon solvent used as the compatible substance (D) include aromatic hydrocarbon solvents. Among them, aromatic hydrocarbon solvents are preferable, in view of the compatibility to the curable silicone composition (A1). Examples of the aromatic hydrocarbon solvents include aromatic hydrocarbon solvents having about 6 to 10 carbon atoms such as toluene, xylene, mesitylene, ethyl benzene, propyl benzene, butyl benzene, and t-butyl benzene, preferably toluene and xylene.

In the mixed composition, the content of the compatible substance (D) is preferably 6 to 60 parts by mass with respect to 100 parts by mass of a total of the curable silicone composition (A1) and the hydrocarbon compound (B). When the content is 6 parts by mass or more, the uniformity when the hydrocarbon compound (B) is mixed with the curable silicone composition (A1) can be sufficiently enhanced. When the content is 60 parts by mass or less, effects according to the amount of the compatible substance (D) used can be obtained. From these points of view, the content of the compatible substance (D) is more preferably 10 to 50 parts by mass, further preferably 15 to 45 parts by mass.

At this time, if the hydrocarbon compound (B) is not uniformly mixed, the hydrocarbon compound remains undissolved, and, as a result, a solid hydrocarbon compound is in a dispersed state, for example. Such dispersed solids may have properties as a filler in the mixed composition. In other words, the undissolved solids serve as a part of the filler, which increases the viscosity, and as a result, it may be difficult to increase the amount of the heat-conductive filler to be mixed.

In the mixed composition, the content of the compatible substance (D) is preferably larger than the content of the hydrocarbon compound (B), in view of enhancing the dispersibility of the hydrocarbon compound (B).

The compatible substance (D) preferably partially or fully volatilizes by heating in step Y. Accordingly, the compatible substance (D) may not be contained in the heat-conductive sheet, or may be contained in the heat-conductive sheet in an amount of less than the content in the mixed composition.

The detailed descriptions of the components other than the compatible substance (D) in the mixed composition (that is, the curable silicone composition (A1), the hydrocarbon compound (B), the heat-conductive filler (C), other additives, etc.) are as described above. The contents of the hydrocarbon compound (B) and the heat-conductive filler (C) in the mixed composition are also as mentioned above. Although the content of each component shown above is the amount with respect to 100 parts by mass of a total of the silicone matrix (A) and the hydrocarbon compound (B), the amount in the mixed composition is an amount with respect to 100 parts by mass of a total of the curable silicone composition (A1) and the hydrocarbon compound (B).

(Step Y)

Step Y is a step of curing the mixed composition by heating. The temperature when heating the mixed composition is not specifically limited as long as the curable silicone composition (A1) can be cured by heating. The temperature may be higher than room temperature (23°C), and is preferably 50°C or more. Further, the heating temperature is not specifically limited and the heating temperature may be about a temperature at which the heat-conductive sheet and the mixed composition are not thermally degraded, and is, for example, 180°C or less, and preferably 150°C or less. The mixed composition may be heated in a single stage or in two or more stages. When heating in two or more stages, the heating temperature may fall within the aforementioned range in at least any one of the stages but preferably falls within the aforementioned range in all the stages. The total heating time is, for example, about 10 minutes to 3 hours. When heating in two or more stages, the mixed composition may be semi-cured in the first stage, and the mixed composition may be fully cured by heating in the second and subsequent stages, for example.

In step Y, the mixed composition may be formed into a predetermined shape such as a block and a sheet, and cured by heating. In the case where the mixed composition contains the anisotropic filler as the heat-conductive filler (C), the anisotropic filler is preferably oriented in one direction before the mixed composition is cured by heating in step Y. The anisotropic filler can be oriented by the magnetic field orientation method or the flow orientation method, and is preferably oriented by the magnetic field orientation method.

In the magnetic field orientation method, the mixed composition may be injected into a mold or the like and placed in the magnetic field, and then the anisotropic filler may be oriented along the magnetic field. Then, an oriented molded product may be obtained by curing the curable silicone composition (A1). The mixed composition may be cured under the heating conditions, as described above.

The oriented molded product is preferably in the form of a block but may be in the form of sheets. When in the form of sheets, the oriented molded product can be used as heat-conductive sheets as they are without slicing. When producing the oriented molded product in the form of a block, the orientation of the anisotropic filler is enhanced.

In the magnetic field orientation method, a release film may be disposed on the portion in contact with the mixed composition in the mold. The release film to be used is, for example, a resin film having good releasability or a resin film having one side treated with a release agent. Use of a release film makes it easy to release the oriented molded product from the mold.

In the magnetic field orientation method, the viscosity of the mixed composition to be used is preferably 10 to 300 Pa s in view of orientation of the magnetic field. When it is 10 Pa s or more, the heat-conductive filler (C) is difficult to settle. When it is 300 Pa s or less, the mixed composition has an improved fluidity to appropriately orient the anisotropic filler in the magnetic field, and thus the problems, such as the orientation taking too much time, do not arise. The viscosity is measured using a rotational viscometer (Brookfield viscometer DV-E, spindle SC4-14) at 25°C and a rotational speed of 10 rpm.

In the case of using the heat-conductive filler (C) difficult to settle or combining with an additive such as an anti-settling agent, the viscosity of the mixed composition may be less than 10 Pa s.

For the magnetic field orientation method, a superconducting magnet, a permanent magnet, an electromagnet, or the like can be mentioned as a magnetic force line source for applying the magnetic force lines. A superconducting magnet is preferable in view of generating a magnetic field with high magnetic flux density. The magnetic flux density of the magnetic field generated from such a magnetic force line source is preferably 1 to 30 tesla. When the magnetic flux density is 1 tesla or more, the anisotropic filler made of carbon materials or the like can be easily oriented. When it is 30 tesla or less, practical production is enabled.

In the flow orientation method, a shear force is applied to the mixed composition, to produce a primary sheet in which the anisotropic filler is oriented along the plane direction. More specifically, in the flow orientation method, the mixed composition prepared in step X is first flattened and stretched while applying a shear force to form a sheet (primary sheet). The anisotropic filler can be oriented in the shearing direction by applying a shear force. For forming the sheet, the mixed composition may be applied onto a base film, for example, using a coating applicator such as a bar coater and a doctor blade, or by extrusion molding or discharging from a nozzle, and then the applied mixed composition may be dried, semi-cured, or full cured, as required. The thickness of the primary sheet is preferably about 50 to 5000 $\mu$m. In the primary sheet, the anisotropic filler is oriented in one direction along the plane direction of the sheet.

The mixed composition used in the flow orientation method has a relatively high viscosity so that a shear force is applied when the composition is stretched into a sheet. Specifically, the viscosity of the mixed composition is preferably 3 to 500 Pa s.

The primary sheet may be used as a heat-conductive sheet as it is without being formed into a block, as will be described below. Alternatively, a laminate block (an oriented molded product in the form of a block) may be formed by layering a plurality of primary sheets so that the orientation directions coincide, and bonding the primary sheets to each other by hot press or the like while optionally heating for curing.

In the case of forming a laminate block, at least one of the surfaces of the primary sheets that are to face each other may be irradiated with vacuum ultraviolet rays before the primary sheets are layered. When the primary sheets are layered through the surface irradiated with vacuum ultraviolet rays, the primary sheets can be bonded each other firmly. In the case of irradiation with vacuum ultraviolet rays, the mixed composition may be fully cured when producing the primary sheets, and curing by heating or the like is not necessary when the primary sheets are layered to form a laminate block.

Also in the flow orientation method, the mixed composition may be cured under the heating conditions as described above.

In the case of forming an oriented molded product in the form of a block as mentioned above, the oriented molded product obtained may be cut by slicing or the like in a direction perpendicular to the direction in which the anisotropic filler are oriented, to form sheet-form products. Slicing may be performed, for example, with a shearing blade. As a result of cutting such as slicing, the sheet-form products have the tips of the anisotropic filler exposed from the binder component in each surface that is a cut surface.

The sheet-form products obtained by cutting may be used as the heat-conductive sheet as they are or may be subjected to another treatment. For example, each surface that is a cut surface may be polished. The surface may be polished using polishing paper, for example.

[Usage of heat-conductive sheet]

The heat-conductive sheet of the present invention is used inside an electronic device or the like. Specifically, the heat-conductive sheet is interposed between two members and is used to conduct heat from one member to the other member. Specifically, the heat-conductive sheet is interposed between a heating element and a heat sink, to transfer heat generated in the heating element to the heat sink by heat conduction and dissipate the heat from the heat sink. Here, examples of the heating element include various electronic parts used inside electronic devices such as CPUs, power amplifiers, and power sources. Examples of the heat sink include heat sinks, heat pumps, and metal housings of electronic devices. The heat-conductive sheet may be compressed with its two surfaces in close contact with the heating element and the heat sink, respectively, when use.

[Method for mounting heat-conductive sheet]

The present invention also provides a method for mounting a heat-conductive sheet. The heat-conductive sheet of the present invention comprises a binder component that is a mixture of the silicone matrix (A) and the hydrocarbon compound (B), and the heat-conductive filler (C) dispersed in the binder component, and has a shape retention, as mentioned above.

The heat-conductive sheet of the present invention can be mounted stably between two members (between the first and second members) by the mounting method comprising steps 1 to 3 below.

Step 1: the step of disposing the heat-conductive sheet on the surface of the first member;
Step 2: the step of heating the heat-conductive sheet;
Step 3: the step of disposing a second member on a surface of the heat-conductive sheet, the surface being opposite from the first member side, and pressurizing the heat-conductive sheet, to install the heat-conducting sheet between the first and second members.

In this mounting method, the first and second members are not specifically limited; however, one may be a heating element, and the other may be a heat sink. The detailed descriptions of the heating element and the heat sink are as described above.

(Step 1)

In step 1, the heat-conductive sheet is disposed on the surface of the first member. The method for disposing the heat-conductive sheet is not specifically limited, and the heat-conductive sheet may be disposed such that one surface thereof is brought in contact with the first member.

In this method, it is preferable to perform step 2 after step 1, as will be described below. In such a case, the heat-conductive sheet having resilience before heating is disposed on the surface of the first member, and thus the workability in step 1 is good.

(Step 2)

In step 2, the heat-conductive sheet is heated. Step 2 may be performed after step 1, may be performed before step 1, or may be performed concurrently with step 1. However, step 2 is preferably performed after step 1, as described above. In other words, it is preferable that the heat-conductive sheet disposed on the surface of the first member should be heated in step 2.

In step 2, the heat-conductive sheet may be heated to a temperature equal to or higher than the melting point of the hydrocarbon compound (B). Accordingly, the heat-conductive sheet may be heated to a temperature higher than normal temperature (23°C). It is heated to preferably 40°C or more, more preferably 50°C or more, further preferably 60°C or more, in view of reliably melting the hydrocarbon compound (B) to enhance the softness of the heat-conductive sheet when installed (step 3 described later).

In view of preventing the heat-conductive sheet from being heated more than necessary, the heat-conductive sheet may be heated to 100°C or less, preferably 90°C or less, more preferably 85°C or less.

When heated to a temperature equal to or higher than the melting point of the hydrocarbon compound (B) in step 2, the heat-conductive sheet can be easily fixed to the first and second members through the melted hydrocarbon compound (B) by pressurization in step 3.

The method for heating the heat-conductive sheet is not specifically limited, and the heat-conductive sheet may be heated by a heating device such as an infrared heater, a hot air heater, or a heat transfer heater.

Conventionally, a phase change sheet is generally softened or melted by heating of a heating element constituting any one of the first and second members. In contrast, the heat-conductive sheet in the mounting method is preferably heated by a heating device different from the heating element before being sandwiched between the first and second members. Such an embodiment enables the heat-conductive sheet to be fixed to the first and second members before the electronic device is used. Accordingly, it is also possible to install the heat-conductive sheet compressed at a compression ratio as designed.

(Step 3)

In step 3, a second member is disposed on a surface of the heat-conductive sheet, the surface being opposite from the first member side, and the heat-conductive sheet is pressurized to install the heat-conducting sheet between the first and second members.

In step 3, the second member may be disposed further on the heat-conductive sheet disposed on the surface of the first member, thereby sandwiching the heat-conductive sheet between the first and second members.

Step 3 may be performed concurrently with step 2 but is preferably performed after step 2. Accordingly, in step 3, the second member may be disposed further on the heat-conductive sheet disposed on the surface of the first member and already heated.

In this mounting method, it is more preferable to perform step 1, step 2, and step 3 in this order. Performing the steps in this order improves the workability.

The heat-conductive sheet sandwiched between the first and second members in step 3 has been heated in step 2 and thus may be further pressurized in the thickness direction in the heated state, in step 3. Here, pressurization may be performed, for example, by pressing the heat-conductive sheet sandwiched between the first and second members by the first and second members further in the thickness direction.

Since the temperature of the heat-conductive sheet becomes a temperature equal to or higher than the melting point of the hydrocarbon compound (B) during pressurization in step 3 to melt the hydrocarbon compound (B), the heat-conductive sheet may be fixed to the first and second members by the melted hydrocarbon compound (B).

As has been described above, the heat-conductive sheet of the present invention has a certain or more softness when heated and thus can follow the first and second members by pressurization in step 3. Accordingly, even if the first and second members have projections and recesses, the heat-conductive sheet can be in close contact with the first and second members to prevent increase in the heat resistance. Further, the heat-conductive sheet can be installed without high stress applied on the first and second members. Further, the heat-conductive sheet has a shape retention even when heated, and accordingly, pump-outs are suppressed to enhance the reliability even when used in the compressed state, as described above. Further, since the heat-conductive sheet has a certain resilience before heating, the workability when installed can be improved.

[Heat dissipating member]

The present invention also provides a heat dissipating member comprising the aforementioned heat-conductive sheet and a heat sink, wherein the heat-conductive sheet is mounted on the surface of the heat sink. Such a heat dissipating member can be obtained, for example, by disposing the heat-conductive sheet on the surface of the heat sink and fixing the heat-conductive sheet to the surface of the heat sink. Here, the heat-conductive sheet may be fixed to the surface of the heat sink, for example, by heating it to a temperature of the melting point of the hydrocarbon compound (B) or higher, followed by pressurization. At this time, the heat-conductive sheet may be disposed on the surface of the heat sink after heating or may be heated after being disposed on the surface of the heat sink.

A heating element may be disposed on the surface of the heat-conductive sheet of the heat dissipating member, the surface being opposite from the heat sink side, thereby mounting the heat-conductive sheet between the heat sink and the heating element. The mounting method may be a method comprising steps 2 and 3 described above, and detailed descriptions are as described above and thus omitted.

Examples

Hereinafter, the present invention will be described in detail by way of examples, but the present invention is not limited at all to these examples.

The heat-conductive sheet obtained in each of Examples and Comparative Examples was evaluated by the following methods.

[Compression ratio]

The heat-conductive sheet was cut into a size of 10 mm $\times$ 10 mm, to measure the compression ratio when compressed at 0.276 MPa (= 40 psi) in an environment of 80°C. Specifically, a test piece was interposed between a pedestal with a flat surface having a size of 10 mm $\times$ 10 mm and a depressor that pressed in parallel, and the thickness $T2$ when the test piece was compressed at 0.276 MPa was measured, to calculate the compression ratio with respect to the initial thickness $T1$, $(T1-T2)/T1$.

[Heat resistance]

The heat resistance was measured using a heat resistance measuring machine as shown in Figure 1 by the method shown below. Specifically, a test piece S for this test with a size of 30 mm × 30 mm was prepared from each sample. Then, the test piece S was attached onto a copper block 22 having a surface for measurement of 25.4 mm × 25.4 mm and lateral surfaces covered with a heat insulator 21, and sandwiched with an upper copper block 23, and a load of a pressure of 40 psi (0.276 MPa) was applied thereto by a load cell 26. Here, the lower copper block 22 was in contact with a heater 24. The upper copper block 23 was covered by the heat insulator 21 and connected to a heat sink 25 with fan. Then, the heater 24 was allowed to produce heat with a calorific value of 25 W, and upon an elapse of 10 minutes after the temperature became substantially steady, the temperature of the upper copper block 23 ($\theta_{j0}$), the temperature of the lower copper block 22 ($\theta_{j1}$), and the calorific value (Q) of the heater were measured, to determine the heat resistance of the sample from formula (1) below. The temperature was adjusted such that the temperature of the heat-conductive sheet was 80°C.

$$\text{Heat resistance} = (\theta_{j1} - \theta_{j0})/Q \cdots \text{formula (1)}$$

In formula (1), $\theta_{j1}$ represents the temperature of the lower copper block 22, $\theta_{j0}$ represents the temperature of the upper copper block 23, and Q represents the calorific value.

[Compressive strain]

The compressive strain was measured according to the method described herein. The test piece used for the measurement had the same shape as the test piece used for determining the compression ratio.

[Example 1]

Side-chain crystalline polyalphaolefin (CPAO, melting point (Tm): 42°C) as the hydrocarbon compound (B), and n-decyltrimethoxysilane as the compatible substance (D) were mixed at 23°C according to the formulation shown in Table 1, to obtain a mixture in which the hydrocarbon compound (B) were dissolved in the compatible substance (D). The mixture obtained, a silicone base resin 1 (alkenyl group-containing organopolysiloxane) and a silicone curing agent (hydrogen organopolysiloxane) as the curable silicone composition (A1), and a catalyst (platinum catalyst) were uniformly mixed, and the resultant was then mixed with the heat-conductive filler (C) according to the formulation shown in Table 1, to obtain a mixed composition.

For the heat-conductive filler (C), aluminum powder (spherical, average particle size: 3 μm, aspect ratio: 1 to 1.5, thermal conductivity: 236 W/m.K) was used as the non-anisotropic filler. Flaky graphite powder (average particle size: 40 μm, aspect ratio: 15, thermal conductivity: 100 W/m·K), graphitized carbon fiber 1 (average fiber length: 77 μm, aspect ratio: 8, thermal conductivity: 1200 W/m·K), and graphitized carbon fiber 2 (average fiber length: 150 μm, aspect ratio: 15, thermal conductivity: 900 W/m·K) were used as the anisotropic filler. The volume filling rate of the heat-conductive filler (C) in each of Examples and Comparative Examples was 66 vol%.

The melting point is a temperature at the endothermic peak in the DTA curve measured by thermogravimetric differential thermal analysis (TGDTA, "DTG-60" available from SHIMADZU CORPORATION) at a heating rate of 1°C/min.

Subsequently, the mixed composition was injected into a mold set so as to have a sufficiently larger thickness than the heat-conductive sheet, and an 8T magnetic field was applied in the thickness direction to orient the anisotropic filler in the thickness direction. Thereafter, the curable silicone composition (A1) was cured by heating at 80°C for 60 minutes, to obtain an oriented molded product in the form of a block.

Then, using a shearing blade, the oriented molded product in the form of a block was sliced into a sheet, to obtain a sheet-form product in the surface of which the anisotropic filler was exposed. The sheet-form product was used as the heat-conductive sheet. The heat-conductive sheet obtained was evaluated. Table 1 shows the evaluation results. As shown in Table 1, the heat-conductive sheet of Example 1 had a high compression ratio and a low heat resistance, thereby ensuring an excellent softness and a good thermal conductivity at high temperature.

Further, the heat-conductive sheet obtained in Example 1 was a sheet having a relative rigidity at room temperature, which was lower than the melting point of the hydrocarbon compound (B). Accordingly, it was possible to obtain the heat-conductive sheet by slicing, as described above, which means excellent handleability. Further, since the compressive strain at 80°C was within a predetermined range, the sheet had a shape retention, and it did not liquefy or a liquid did not flow out. Accordingly, pump-outs did not occur even after compression for a long period of time, and the reliability was thus good. Further, air voids or the like were not found on the surface of the heat-conductive sheet, and the appearance was thus good.

[Examples 2 to 7]

These examples were conducted in the same manner as in Example 1 except that the formulation for the components was changed to those shown in Table 1. Table 1 shows the evaluation results of the heat-conductive sheet obtained in each of Examples 2 to 7. As shown in Table 1, the heat-conductive sheet of each of Examples 2 to 7 had a high compression ratio and a low heat resistance, thereby ensuring an excellent softness and a good thermal conductivity at high temperature.

Further, the heat-conductive sheet obtained in each of Examples 2 to 7 was a sheet having a relative rigidity at room temperature, which was lower than the melting point of the hydrocarbon compound (B). Accordingly, it was possible to obtain the heat-conductive sheet by slicing, as described above, which means excellent handleability. Further, since the compressive strain at 80°C was within a predetermined range, the sheet had a shape retention, and it did not liquefy or a liquid did not flow out. Accordingly, pump-outs did not occur even after compression for a long period of time, and thus the reliability was also good. Further, air voids or the like were not found on the surface of the heat-conductive sheet, and the appearance was thus good.

[Example 8]

This example was conducted in the same manner as in Example 1 except that liquid paraffin (melting point: -9°C) was used as the hydrocarbon compound (B). Table 1 shows the evaluation results of the heat-conductive sheet obtained. As shown in Table 1, the heat-conductive sheet of Example 8 had a high compression ratio and a low heat resistance, thereby ensuring an excellent softness and a good thermal conductivity at high temperature.

Further, the heat-conductive sheet obtained in Example 8 had some softness and a shape retention, at both of room temperature and 80°C. Therefore, the handleability at normal temperature was somewhat poor so that it was difficult to slice; however, it was possible to obtain the heat-conductive sheet. Further, pump-outs did not occur even after compression for a long period of time, and thus the reliability was also good. Further, air voids or the like were not found on the surface of the heat-conductive sheet, and the appearance was thus good.

[Example 9]

This example was conducted in the same manner as in Example 1 except that "vaseline (white)" (melting point: 33°C) available from FUJIFILM Wako Pure Chemical Corporation was used as the hydrocarbon compound (B). Table 1 shows the evaluation results of the heat-conductive sheet obtained. As shown in Table 1, the heat-conductive sheet of Example 9 had a high compression ratio and a low heat resistance, thereby ensuring an excellent softness and a good thermal conductivity at high temperature.

Further, the heat-conductive sheet obtained in Example 9 was a sheet having a relative rigidity at room temperature, which was lower than the melting point of the hydrocarbon compound (B). Accordingly, it was possible to obtain the heat-conductive sheet by slicing, as described above, which means excellent handleability. Further, since the compressive strain at 80°C was within a predetermined range, the sheet had a shape retention, and it did not liquefy or a liquid did not flow out. Accordingly, pump-outs did not occur even after compression for a long period of time, and thus the reliability was also good. Further, air voids or the like were not found on the surface of the heat-conductive sheet, and the appearance was thus good.

[Example 10]

This example was conducted in the same manner as in Example 1 except that dimethyldimethoxysilane was used as the compatible substance (D). In Example 10, there was a tendency that the hydrocarbon compound (B) was difficult to be dissolved in the compatible substance (D), and it took a long time for dissolution; however, a heat-conductive sheet was obtained without problems. Table 1 shows the evaluation results of the heat-conductive sheet obtained. As shown in Table 1, the heat-conductive sheet of Example 10 had a high compression ratio and a low heat resistance, thereby ensuring an excellent softness and a good thermal conductivity at high temperature.

Further, the heat-conductive sheet obtained in Example 10 was a sheet having a relative rigidity at room temperature, which was lower than the melting point of the hydrocarbon compound (B). Accordingly, it was possible to obtain the heat-conductive sheet by slicing, as described above, which means excellent handleability. Further, since the compressive strain at 80°C was within a predetermined range, the sheet had a shape retention, and it did not liquefy or a liquid did not flow out. Accordingly, pump-outs did not occur even after compression for a long period of time, and thus the reliability was also good. Further, air voids or the like were not found on the surface of the heat-conductive sheet, and the appearance was thus good.

[Example 11]

This example was conducted in the same manner as in Example 1 except that toluene was used as the compatible substance (D). Table 1 shows the evaluation results of the heat-conductive sheet obtained. As shown in Table 1, the heat-conductive sheet of Example 11 had a high compression ratio and a low heat resistance, thereby ensuring an excellent softness at high temperature and a good thermal conductivity.
In the heat-conductive sheet obtained in Example 11, air voids were found on the surface of the heat-conductive sheet, and the appearance was poorer than that in Example 1. However, it was a sheet having a relative rigidity at room temperature, which was lower than the melting point of the hydrocarbon compound (B). Therefore, it was possible to obtain the heat-conductive sheet by slicing, as described above, which means excellent handleability. Further, since the compressive strain at 80°C was within a predetermined range, the sheet had a shape retention, and it did not liquefy or a liquid did not flow out.
Accordingly, pump-outs did not occur even after compression for a long period of time, and thus the reliability was also good.

[Example 12]

This example was conducted in the same manner as in Example 1 except that n-octyltriethoxysilane was used as the compatible substance (D). Table 1 shows the evaluation results of the heat-conductive sheet obtained. As shown in Table 1, the heat-conductive sheet of Example 12 had a high compression ratio and a low heat resistance, thereby ensuring an excellent softness and a good thermal conductivity at high temperature.
Further, the heat-conductive sheet obtained in Example 12 was a sheet having a relative rigidity at room temperature, which was lower than the melting point of the hydrocarbon compound (B). Accordingly, it was possible to obtain the heat-conductive sheet by slicing, as described above, which means excellent handleability. Further, since the compressive strain at 80°C was within a predetermined range, the sheet had a shape retention, and it did not liquefy or a liquid did not flow out. Accordingly, pump-outs did not occur even after compression for a long period of time, and thus the reliability was also good. Further, air voids or the like were not found on the surface of the heat-conductive sheet, and the appearance was thus good.

[Example 13]

This example was conducted in the same manner as in Example 1 except that the formulation for components was changed to that shown in Table 1. Table 1 shows the evaluation results of the heat-conductive sheet obtained in Example 13.
As shown in Table 1, the heat-conductive sheet of Example 13 had a high compression ratio and a low heat resistance, thereby ensuring an excellent softness and a good thermal conductivity at high temperature.
Further, the heat-conductive sheet obtained in Example 13 was a sheet having a relative rigidity at room temperature, which was lower than the melting point of the hydrocarbon compound (B). Accordingly, it was possible to obtain the heat-conductive sheet by slicing, as described above, which means excellent handleability. Further, since the compressive strain at 80°C was within a predetermined range, the sheet had a shape retention, and it did not liquefy or a liquid did not flow out. Accordingly, pump-outs did not occur even after compression for a long period of time, and thus the reliability was also good. Further, air voids or the like were not found on the surface of the heat-conductive sheet, and the appearance was thus good.

[Comparative Example 1]

This example was conducted in the same manner as in Example 1 except that a heat-conductive sheet was produced by using a mixed composition obtained by mixing the components without the hydrocarbon compound (B) according to the formulation shown in Table 1. Table 1 shows the evaluation results of the heat-conductive sheet obtained in Comparative Example 1. As shown in Table 1, the heat-conductive sheet of Comparative Example 1 had a low compression ratio at high temperature and did not have a certain softness at high temperature. Therefore, the followability to heating elements or heat sinks was insufficient, and the heat resistance was thus high.

[Comparative Example 2]

This example was conducted in the same manner as in Example 1 except that a mixed composition obtained by mixing the components without the compatible substance (D) according to the formulation shown in Table 1 was used. The hydrocarbon compound (B) were not dispersed in the curable silicone composition (A1), and it was thus not possible to obtain an oriented molded product in the form of a block.

[Comparative Example 3]

This example was conducted in the same manner as in Example 1, except that sorbitan trioleinate was used instead of the compatible substance (D), and that a mixed composition obtained by mixing the components according to the formulation shown in Table 1 was used. The hydrocarbon compound (B) were not dispersed in the curable silicone composition (A1), and it was thus not possible to obtain an oriented molded product in the form of a block.

[Table 1]

| | Example 1 | Example 2 | Example 3 | Example 4 | Example 5 | Example 6 | Example 7 | Example 8 | Example 9 | Example 10 | Example 11 | Example 12 | Example 13 | Comparative Example 1 | Comparative Example 2 | Comparative Example 3 |
|---|---|---|---|---|---|---|---|---|---|---|---|---|---|---|---|---|

(continued)

| | | | Example 1 | Example 2 | Example 3 | Example 4 | Example 5 | Example 6 | Example 7 | Example 8 | Example 9 | Example 10 | Example 11 | Example 12 | Example 13 | Comparative Example 1 | Comparative Example 2 | Comparative Example 3 |
|---|---|---|---|---|---|---|---|---|---|---|---|---|---|---|---|---|---|---|
| Formulation (parts by mass) | Curable silicone composition (A1) | Silicone base resin | 81.8 | 87.3 | 86.4 | 86.4 | 72.7 | 72.7 | 72.7 | 81.8 | 81.8 | 81.8 | 81.8 | 81.8 | 900 | 90.9 | 81.8 | 81.8 |
| | | Silicone curing agent | 8.2 | 9.7 | 8.6 | 8.6 | 7.3 | 7.3 | 7.3 | 8.2 | 8.2 | 8.2 | 8.2 | 8.2 | 9.0 | 9.1 | 8.2 | 8.2 |
| | Additive | Catalyst | 0.1 | 0.1 | 0.1 | 0.1 | 0.1 | 0.1 | 0.1 | 0.1 | 0.1 | 0.1 | 0.1 | 0.1 | 0.1 | 0.1 | 0.1 | 0.1 |
| | Hydrocarbon compound (B) | CPAO | 10 | 3 | 5 | 5 | 20 | 20 | 20 | | | 10 | 10 | 10 | 1 | | 10 | 10 |
| | | Liquid paraffin | | | | | | | | 10 | | | | | | | | |
| | | White vaseline | | | | | | | | | 10 | | | | | | | |
| | Heat-conductive filler (C) | Aluminum powder 3 μm (average particle size) | 243 | 243 | 243 | 243 | 243 | 243 | 243 | 243 | 243 | 243 | 243 | 243 | 243 | 243 | 243 | 243 |
| | | Flaky graphite powder 40 μm (average long-axis length) | 20 | 20 | 20 | 20 | 20 | 20 | 20 | 20 | 20 | 20 | 20 | 20 | 20 | 20 | 20 | 20 |
| | | Graphitized carbon fiber 1 77 μm (average fiber length) | 140 | 140 | 140 | 140 | 140 | 140 | 140 | 140 | 140 | 140 | 140 | 140 | 140 | 140 | 140 | 140 |
| | | Graphitized carbon fiber 2 150 μm (average fiber length) | 10 | 10 | 10 | 10 | 10 | 10 | 10 | 10 | 10 | 10 | 10 | 10 | 10 | 10 | 10 | 10 |
| | Compatible substance (D) | n-Decyltrimethoxysilane | 22 | 22 | 22 | 10 | 22 | 32 | 42 | 22 | 22 | | | | 22 | 22 | | |
| | | Dimethylmethoxysilane | | | | | | | | | | 22 | | | | | | |
| | | n-Octyltriethoxysilane | | | | | | | | | | | 22 | | | | | |
| | | Toluene | | | | | | | | | | | | 22 | | | | |
| | Others | Sorbitan trioleate | | | | | | | | | | | | | | | | 22 |

(continued)

| Measurement re-sults | | Example 1 | Example 2 | Example 3 | Example 4 | Example 5 | Example 6 | Example 7 | Example 8 | Example 9 | Example 10 | Example 11 | Example 12 | Example 13 | Comparative Example 1 | Comparative Example 2 | Comparative Example 3 |
|---|---|---|---|---|---|---|---|---|---|---|---|---|---|---|---|---|---|
| | Sample Initial thickness, T1 (mm) | 0.221 | 0.206 | 0.204 | 0.212 | 0.224 | 0.225 | 0.221 | 0.212 | 0.217 | 0.221 | 0.217 | 0.202 | 0.205 | 0.201 | - | - |
| | Thickness found in measurement (40 psi), T2 (mm) | 0.171 | 0.175 | 0.159 | 0.165 | 0.137 | 0.133 | 0.131 | 0.151 | 0.142 | 0.156 | 0.144 | 0.139 | 0.164 | 0.176 | - | - |
| | 40-psi compression ratio | 23% | 15% | 22% | 18% | 32% | 34% | 35% | 25% | 29% | 22% | 28% | 31% | 18% | 12% | - | - |
| | Compressive strain (%) | 27.7% | 20.2% | 22.3% | 21.5% | 31.5% | 30.8% | 32.2% | 29.5% | 282% | 268% | 285% | 258% | 20.3% | 198% | - | - |
| | Heat resistance (°C-in$^2$/W) @40psi 80°C | 0.020 | 0.019 | 0.019 | 0.020 | 0.020 | 0.020 | 0.020 | 0.019 | 0.020 | 0.020 | 0.020 | 0.020 | 0.02 | 0.022 | - | - |

In each of Examples mentioned above, the hydrocarbon compound (B) was dispersed in the silicone matrix (A) by using the compatible substance (D). Therefore, the heat-conductive sheet of each of Examples had a shape retention and also a softness at high temperature, and thus exhibited a good followability to the heating element and the heat sink during use. In addition, the heat-conductive sheet of each of Examples was easily compressed to have a low heat resistance, and further has good reliability and a good handleability.

In contrast, the heat-conductive sheet of Comparative Example 1, which was free from the hydrocarbon compound (B) in the binder component, had an insufficient softness at high temperature, and therefore a poor followability and compression ratio during use, which resulted in high heat resistance. Further, in Comparative Examples 2 and 3, since the compatible substance (D) was not used, the hydrocarbon compound (B) was not dispersed in the silicone matrix (A), so that it was impossible to produce a heat-conductive sheet.

Reference Signs List

    21: Heat insulator
    22: Lower copper block
    23: Upper copper block
    24: Heater
    25: Heat sink
    26: Load cell
    S: Test piece
    $\theta_{j0}$: Temperature of upper copper block
    $\theta_{j1}$: Temperature of lower copper block

**Claims**

1. A heat-conductive sheet comprising:

   a binder component that is a mixture of a silicone matrix (A) and a hydrocarbon compound (B); and
   a heat-conductive filler (C) dispersed in the binder component,
   wherein the heat-conductive sheet has a compression ratio at 80°C and 0.276 MPa of 15% or more, and has a shape retention.

2. The heat-conductive sheet according to claim 1, wherein the hydrocarbon compound (B) has a melting point higher than 23°C and 80°C or less.

3. The heat-conductive sheet according to claim 1 or 2, wherein the hydrocarbon compound (B) is crystalline polyalphaolefin.

4. The heat-conductive sheet according to any one of claims 1 to 3, wherein the heat-conductive sheet has a content of the hydrocarbon compound (B) of 1 to 50 parts by mass, with respect to 100 parts by mass of a total of the silicone matrix (A) and the hydrocarbon compound (B).

5. The heat-conductive sheet according to any one of claims 1 to 4, wherein the heat-conductive filler (C) comprises an anisotropic filler, and the anisotropic filler is oriented in the thickness direction.

6. The heat-conductive sheet according to any one of claims 1 to 5, wherein a volume filling rate of the heat-conductive filler (C) is 30 to 85 vol%.

7. A heat dissipating member comprising: the heat-conductive sheet according to any one of claims 1 to 6; and a heat sink, wherein the heat-conductive sheet is mounted on the surface of the heat sink.

8. A method for mounting a heat-conductive sheet, the method comprising:

   a step of disposing the heat-conductive sheet on a surface of a first member, wherein the sheet comprises a binder component that is a mixture of a silicone matrix (A) and a hydrocarbon compound (B), and a heat-conductive filler (C) dispersed in the binder component, and has a shape retention;

a step of heating the heat-conductive sheet; and

a step of disposing a second member on a surface of the heat-conductive sheet, the surface being opposite from the first member side, and pressurizing the heat-conductive sheet, to install the heat-conducting sheet between the first and second members.

9. The method for mounting a heat-conductive sheet according to claim 8, wherein the hydrocarbon compound (B) has a melting point higher than 23°C, and the heat-conductive sheet is heated to a temperature equal to or higher than the melting point.

10. A method for producing a heat-conductive sheet, the method comprising:

a step of mixing at least a curable silicone composition (A1), a hydrocarbon compound (B), a heat-conductive filler (C), and a compatible substance (D), to obtain a mixed composition; and

a step of curing the mixed composition by heating.

11. The method for producing a heat-conductive sheet according to claim 10, wherein the compatible substance (D) is an alkoxysilane compound.

# Fig.1

## INTERNATIONAL SEARCH REPORT

| | International application No. |
| --- | --- |
| | **PCT/JP2021/027302** |

| | |
| --- | --- |
| **A. CLASSIFICATION OF SUBJECT MATTER** | |
| *H05K 7/20*(2006.01)i; *C08K 3/01*(2018.01)i; *C08L 23/00*(2006.01)i; *C08L 83/04*(2006.01)i; *H01L 23/36*(2006.01)i<br>FI: H05K7/20 F; H01L23/36 D; C08L83/04; C08L23/00; C08K3/01 | |
| According to International Patent Classification (IPC) or to both national classification and IPC | |

**B. FIELDS SEARCHED**

Minimum documentation searched (classification system followed by classification symbols)

H05K7/20; C08K3/01; C08L23/00; C08L83/04; H01L23/36

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X<br><br>Y | JP 2010-185052 A (IDEMITSU KOSAN CO.) 26 August 2010 (2010-08-26)<br>paragraphs [0006], [0015], [0016], [0027], [0037], [0038], [0050], [0051], [0080]<br>paragraphs [0006], [0015], [0016], [0027], [0037], [0038], [0050], [0051], [0080] | 1-9<br><br>1-9 |
| Y | WO 2020/039560 A1 (HITACHI CHEMICAL CO., LTD.) 27 February 2020 (2020-02-27)<br>paragraphs [0033], [0042], [0045], [0046] | 1-9 |
| X | JP 2013-127035 A (TWO-ONE KK) 27 June 2013 (2013-06-27)<br>paragraphs [0014], [0017], [0021], [0028], [0041], [0048], [0049], [0094] | 10-11 |

| ☐ Further documents are listed in the continuation of Box C. | ☑ See patent family annex. |
| --- | --- |

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **08 October 2021** | **19 October 2021** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

## INTERNATIONAL SEARCH REPORT
**Information on patent family members**

International application No.

**PCT/JP2021/027302**

| Patent document cited in search report | | | Publication date (day/month/year) | Patent family member(s) | Publication date (day/month/year) |
|---|---|---|---|---|---|
| JP | 2010-185052 | A | 26 August 2010 | (Family: none) | |
| WO | 2020/039560 | A1 | 27 February 2020 | US 2021/0183733 A1 paragraphs [0070], [0080], [0083]-[0085] CN 1126022189 A KR 10-2021-0046671 A TW 202020106 A | |
| JP | 2013-127035 | A | 27 June 2013 | (Family: none) | |

Form PCT/ISA/210 (patent family annex) (January 2015)

**REFERENCES CITED IN THE DESCRIPTION**

**Patent documents cited in the description**

- JP 2004331835 A
- JP 2002234952 A
- JP 2001291807 A